# EUROPEAN PATENT APPLICATION

(11) **EP 4 661 055 A1**
(43) Date of publication of application: **10.12.2025**
(21) Application number: 24750027.5
(22) Date of filing: 22.01.2024
(51) Int. Cl.: H01L 21/302, H01L 21/3065

(54) **ETCHING METHOD AND ETCHING DEVICE**

(30) Priority: 30.01.2023 JP 2023012160
(71) Applicant: Tokyo Electron Limited, Tokyo 107-6325 (JP)
(72) Inventor: TODA, Satoshi, Yamanashi 4070192 (JP); NAKAGOMI, Ken, Yamanashi 4070192 (JP); IMAMURA, Kentaro, Yamanashi 4070192 (JP); IRIE, Shinji, Yamanashi 4070192 (JP)
(74) Representative: Diehl & Partner
(86) International application number: PCT/JP2024/001693
(87) International publication number: WO 2024/162075

(57) **Abstract**

An etching method includes etching a silicon layer by supplying a halogen-containing gas and an amine gas to a substrate including the silicon layer formed on a surface of the substrate.

## Description

### TECHNICAL FIELD

The present disclosure relates to an etching method and an etching apparatus.

### BACKGROUND

In manufacturing a semiconductor device, Si layers and SiGe layers are formed on a surface of a semiconductor wafer (hereinafter, referred to as a wafer) serving as a substrate, and in some cases, the Si layers may be selectively etched. In Patent Document 1, etching a silicon oxide layer using hydrogen fluoride gas and trimethylamine gas is disclosed.

### [Prior Art Documents]

### [Patent Documents]

Patent Document 1: Japanese Patent Laid-open Publication No. 2022-039965

### SUMMARY

The present disclosure provides a technology for etching a silicon layer, which can make the silicon layer after etching have a desired shape.

An etching method of the present disclosure includes etching a silicon layer by supplying a halogen-containing gas and an amine gas to a substrate including the silicon layer formed on a surface of the substrate.

According to the present disclosure in some embodiments, when etching a silicon layer, it is possible to make the silicon layer after etching have a desired shape.

### BRIEF DESCRIPTION OF DRAWINGS

FIG. 1 is a longitudinal front view of a wafer on which a processing according to each embodiment of the present disclosure is performed.
FIG. 2 is an explanatory view illustrating a change of a recess caused by an etching process according to a comparative embodiment
FIG. 3 is an explanatory view illustrating a change of the recess caused by the etching process according to the comparative embodiment.
FIG. 4 is an explanatory view illustrating a change of a recess caused by an etching process according to a first embodiment.
FIG. 5 is an explanatory view illustrating the change of the recess caused by the etching process according to the first embodiment.
FIG. 6 is a longitudinal front view of the wafer after the etching process according to the first embodiment.
FIG. 7 is an explanatory view illustrating a change of a recess caused by an etching process according to a second embodiment.
FIG. 8 is an explanatory view illustrating the change of the recess caused by the etching process according to the second embodiment.
FIG. 9 is a longitudinal front view of the wafer after the etching process according to the second embodiment.
FIG. 10 is a longitudinal front view illustrating an example of an etching apparatus for performing a processing of the present disclosure.
FIG. 11 is a graph showing a result of an evaluation test.
FIG. 12 is a SEM image showing a result of the evaluation test.
FIG. 13 is a SEM image showing a surface of a wafer before the evaluation test.
FIG. 14 is a SEM image showing a result of the evaluation test.
FIG. 15 is a graph showing a result of the evaluation test.
FIG. 16 is a SEM image showing a result of the evaluation test.
FIG. 17 is a SEM image showing a result of the evaluation test.
FIG. 18 is a SEM image showing a result of the evaluation test.

### DETAILED DESCRIPTION

### <Overview of Etching and Structure of Each Layer on a Substrate>

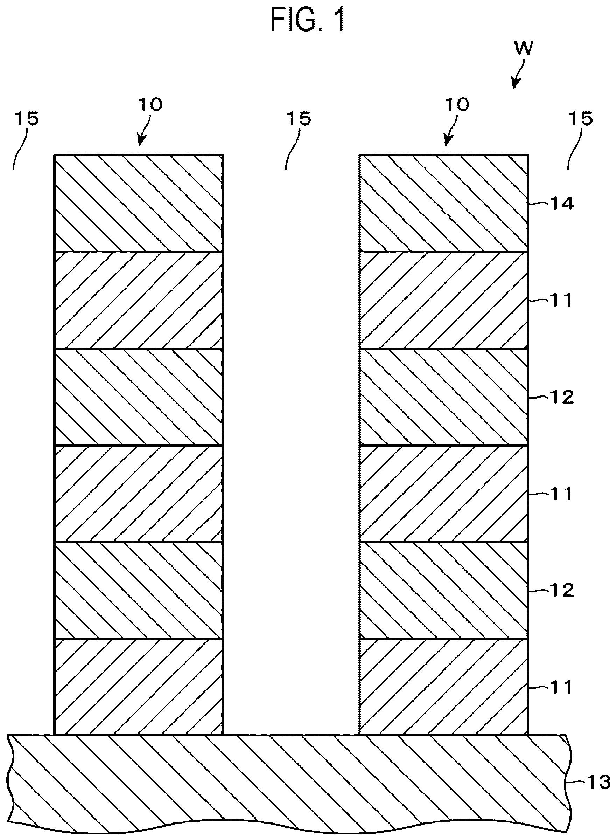

An etching method (etching process according to an embodiment of the present disclosure is described. The etching process is used in, for example, a process of manufacturing a gate all around (GAA) transistor such as a nanosheet or a nanowire from a substrate W in which a plurality of silicon (Si) layers 11 and a plurality of silicon germanium (SiGe) layers, each of which has a thickness of a few nm, are stacked, and is performed without forming plasma around the substrate W. FIG. 1 is a longitudinal front view of the substrate W which is a wafer, and illustrates a state before the etching process is performed.

A surface layer of the substrate W is denoted by a reference numeral 13. Assuming that a thickness direction of the substrate W is a vertical direction, Si layers 11 and SiGe layers 12 are alternately and repeatedly stacked in the vertical direction on the surface layer 13. Therefore, the SiGe layers 12 are brought into contact with the Si layers 11 in the vertical direction. An uppermost layer of the repetition of the Si layers 11 and the SiGe layers 12 is formed by a Si layer 11, and on the Si layer 11, a mask film 14 is stacked to prevent etching of the Si layer 11 from above. The mask film 14, the Si layers 11, and the SiGe layers 12, are stacked on top of each other as described above constitute a stack structure 10, and a groove 15 is formed from an upper end to a lower end of the stack structure 10 so as to divide the stack structure 10 in a horizontal direction in a longitudinal cross-sectional view, and a plurality of grooves 15 are formed to be spaced apart from each other in the horizontal direction. Therefore, side surfaces of the Si layers 11 and the SiGe layers 12 are exposed to a surface of the substrate W via the groove 15, and are exposed to an etching gas that is supplied from above the substrate W and introduced into the groove 15.

In the present embodiment, among the Si layers 11 and the SiGe layers 12, the Si layers 11 are selectively etched from sides. The etching is performed so that a portion of each Si layer 11 remains. Therefore, after the etching, a recess 18 is formed toward a width center of the stack structure 10 by the SiGe layer 12 and the Si layer 11, and it is desirable for the recess 18 to have high rectangularity in the longitudinal cross-sectional view. To explain the rectangularity in more detail, a recess 18 is considered rectangular if a side surface (inner wall surface) of the recess 18 formed by the Si layer 11 forms an angle of 90 degrees with an upper surface and a lower surface of the recess 18, when viewed from the front. A recess 18 having a shape similar to such a recess 18 is a recess 18 having high rectangularity.

In addition to increasing the rectangularity of the recess 18, it is desirable for roughness of a side surface (roughness of a surface) of the Si layer 11, which forms an inner wall of the recess 18, to be suppressed. More specifically, it is desirable for irregularities to be suppressed from forming, thereby increasing smoothness of the side surface. Further, a desired shape of the silicon layer after the above-described etching includes a shape in which the roughness is suppressed.

### <Comparative Embodiment>

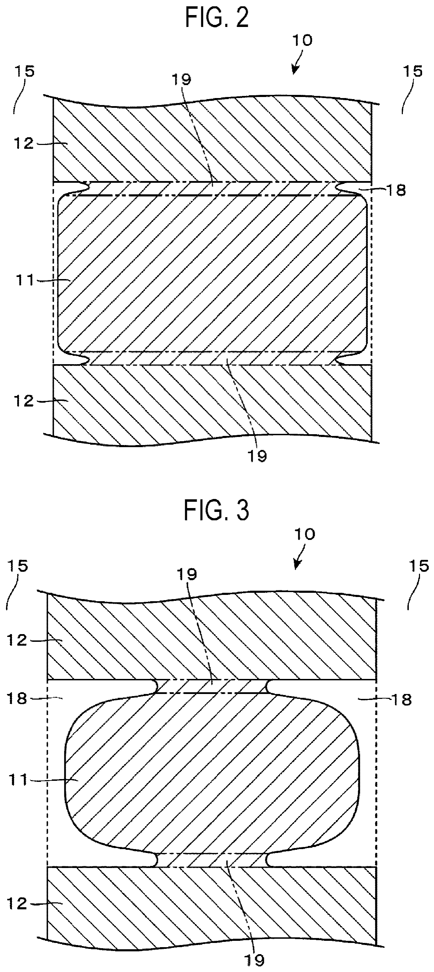

In order to clearly describe the etching process according to the embodiment, first, an etching process according to a comparative embodiment is described with reference to FIGS. 2 and 3. FIGS. 2 and 3 correspond to partially enlarged views of the longitudinal front view shown in FIG. 1, and are explanatory views illustrating changes in the shape of the substrate W during the etching process. FIG. 3 illustrates a state of the substrate W at the end of the etching process.

A method of etching a Si layer, using fluorine (F₂) gas which is a halogen-containing gas and NH₃ gas as etching gas, is known, and in the etching process according to the comparative embodiment, the F₂ gas and the NH₃ gas are simultaneously supplied to the above-described substrate W. As shown in an evaluation test later, by supplying such etching gas, the Si layer 11 is selectively etched with respect to the SiGe layer 12. However, it was confirmed that a region in the vicinity of an interface of the Si layer 11 with the SiGe layer 12 (hereinafter, referred to as an interface vicinity region 19) is, compared to other regions, considerably etched toward the width center of the stack structure 10. Therefore, in the formed recess 18, depths in the horizontal direction vary at portions of the recess 18 when viewed in a vertical direction and thus, the above-described rectangularity of the recess 18 is low.

Diffusion of germanium (Ge) atoms from an adjacent SiGe layer 12 in the above-described interface vicinity region 19 of the Si layer 11 is considered to be the reason why the Si layer 11 is etched in the above-described manner. More specifically, it is presumed that, due to the diffusion, the interface vicinity region 19 has a higher Ge atom concentration than that of other regions of the Si layer 11, resulting in a higher etching rate (etching amount/etching time) than that of the other regions, as illustrated in FIGS. 2 and 3. Although the SiGe layer 12 serving as a diffusion source of Ge atoms has a high Ge atom concentration compared to the interface vicinity region 19 of the Si layer 11, etching hardly occurs, as shown in the evaluation test. The SiGe layer 12 contains a relatively large amount of Ge atoms, and the interface vicinity region 19 contains a very small amount of Ge in the Si due to the diffusion. Therefore, properties the SiGe layer 12 and the interface vicinity region 19 of the Si layer 11 are different, which is considered to be the reason why resistances to the above-described etching gas are different.

In addition, results of the evaluation test to be described later show that the roughness of the Si layer 11 after etching is greater than that of the Si layer 11 before etching. This increase in roughness is caused by by-products that are generated from reactions between the etching gas and the Si layer 11. Specifically, ammonium silicofluoride ((NH₄)₂SiF₆) is generated as a by-product during etching, and a layer of this by-product is formed on the Si layer 11. However, a thickness of the layer varies at different portions on the Si layer 11. At portions of the Si layer 11, at which the thickness of the layer of the by-product is relatively large, contact with the etching gas is interrupted, and etching is hindered. That is, an etching amount varies at different portions of a surface of the Si layer 11, which is considered to result in the increased roughness after etching as described above.

### (First Embodiment)

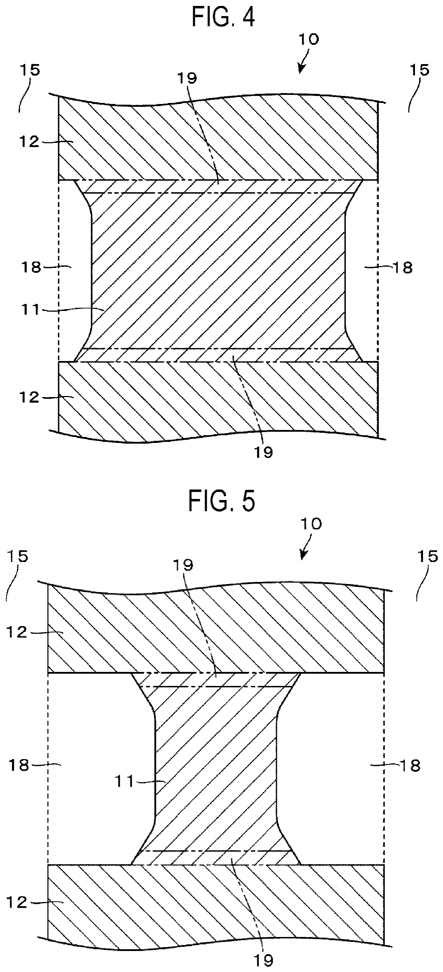

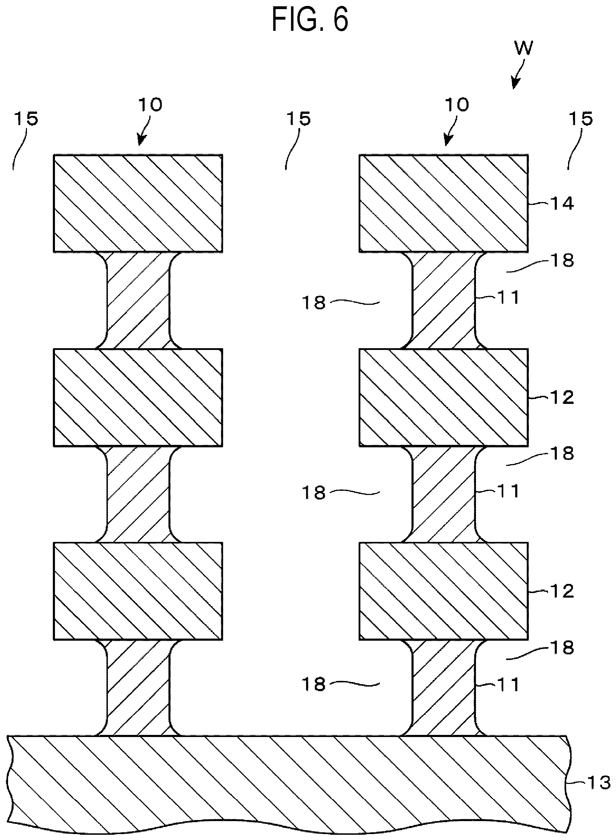

Next, an etching process according to the present embodiment is described with reference to FIGS. 4 to 6. Like FIGS. 2 and 3, FIGS. 4 and 5 are explanatory views illustrating changes in the shape of the substrate W during the etching process, and FIG. 5 shows a state of the substrate W at the end of the etching process. Like FIG. 1, FIG. 6 is a longitudinal front view showing the entire stack structure 10 after the etching process, and FIG. 5 is an enlarged view of a portion of FIG. 6.

The etching gas of the present embodiment is composed of F₂ gas and trimethylamine ((CH₃)₃N, hereinafter, referred to as TMA) gas which is amine gas, and the F₂ gas and the TMA gas are simultaneously supplied to the substrate W. It is considered that etching is performed in a way that the etching amounts of the interface vicinity region 19 and the other regions of the Si layer 11 are substantially uniform (FIG. 4), and as will be shown later in the results of the evaluation test, the rectangularity of recess 18 after etching is increased (FIGS. 5 and 6). That is, when the etching gas of the present embodiment is used, it is difficult for a content ratio of Ge atoms contained in the Si layer 11 to have influence on etching performance of the etching gas.

In addition, the results of the evaluation test to be described later show that using the etching gas of the present embodiment suppresses the increase in the roughness of the Si layer 11 after etching, and the side surface of the Si layer 11 after etching is smoother than the case of using the etching gas of the comparative embodiment. This is considered to result from a difference in the by-products generated in the present embodiment and the comparative embodiment. It is assumed that the by-product of the present embodiment is a substance obtained by replacing a constituent element of ammonia included in ammonium silicofluoride, which is the by-product of the comparative embodiment, with a constituent element of trimethylamine. Further, since the by-product has a higher vapor pressure than ammonium silicofluoride, the by-product vaporizes immediately upon generation and is spaced apart from the side surface of the Si layer 11 without interfering contact between the etching gas and the side surface of the Si layer 11. This is considered to enable the side surface of the Si layer 11 to be etched with high uniformity.

As described above, by the etching process according to the present embodiment, it is possible to increase the rectangularity of the recess 18 formed by the etching, and to suppress the roughness (increase the smoothness) of the side surface of the Si layer 11 after the etching. Further, it is possible to make an etching rate of the Si layer 11 relatively high, as shown in the evaluation test.

### (Second Embodiment)

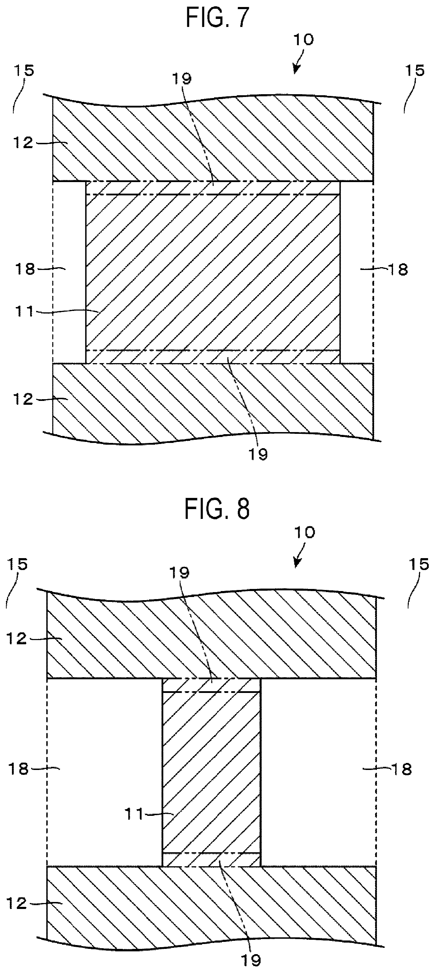

An etching process according to the present embodiment is described with reference to FIGS. 7 to 9. Further, in the description of the present embodiment, differences from the first embodiment are mainly described, and descriptions of the same configurations as the first embodiment are omitted. Like FIG. 1, FIG. 7 is a longitudinal front view of the entire stack structure 10 after the etching process, and FIG. 8 is an enlarged view of a portion of FIG. 6.

The rectangularity of the recess 18 formed in the first embodiment is high as described above. However, as illustrated in FIGS. 5 and 6, etching amount of the interface vicinity region 19 of the Si layer 11 may be smaller than that of the other regions of the Si layer 11. That is, the recess 18 may be formed such that depth decreases toward the SiGe layer 12 which is located at an upper side or a lower side, and an inner upper portion and an inner lower portion form arcs in longitudinal cross-sectional view. In general, this is considered to be caused by a tendency that gas flowing through a gap decreases in flow velocity at a vicinity of walls that form the gap. That is, when the etching gas flows towards an inside of the recess 18, the flow velocity of the etching gas decreases at the vicinity of an upper wall and a lower wall of the recess 18, and the effect of the etching gas becomes relatively small, and this is considered to cause the small etching amount in the interface vicinity region 19.

In the second embodiment, the etching process is performed such that the rectangularity of the recess 18 becomes higher. Specifically, the etching gas of the present embodiment is composed of F₂ gas, TMA gas, and NH₃ gas, and the F₂ gas, the TMA gas, and the NH₃ gas are simultaneously supplied to the substrate W.

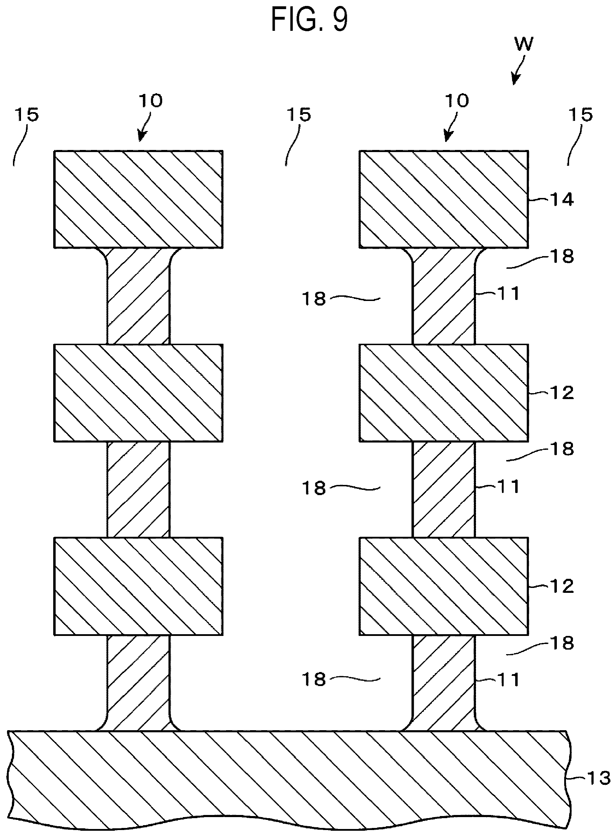

As described in the comparative embodiment, the etching gas contains F₂ gas and NH₃ gas, which makes the etching rate of the interface vicinity region 19 becomes relatively high. Accordingly, in the etching process according to the second embodiment, etching is performed in a way that the etching amounts of the interface vicinity region 19 and the other regions of the Si layer 11 are more uniform (FIG. 7), and the rectangularity of the recess 18 after etching is increased (FIGS. 8 and 9), compared to the etching process according to the first embodiment. Further, as shown in the evaluation test later, according to the second embodiment, it is possible to perform the etching process with a higher etching rate than that of the first embodiment.

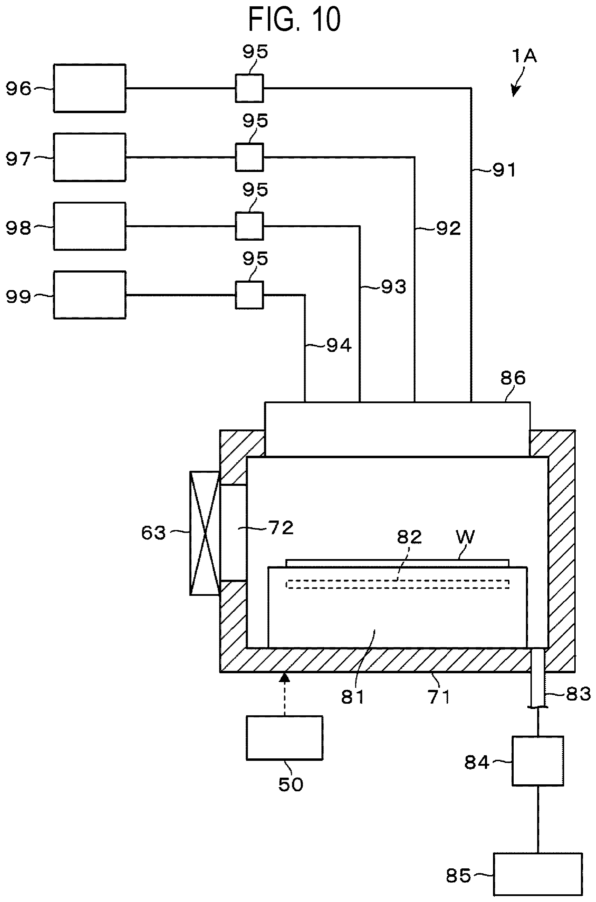

Next, an etching apparatus 1A that performs the etching process according to the present disclosure is described with reference to a longitudinal front view of FIG. 10. The etching apparatus 1A may select and perform the etching method of one of the first embodiment and the second embodiment. Reference numeral 71 is a processing container that constitutes the etching apparatus 1A. Reference numeral 72 is a transfer port 72 for the substrate W which opens to a sidewall of the processing container 71, and is opened and closed by the above-described gate valve 63. A stage 81 that the substrate W is placed on is provided in the processing container 71, and the stage 81 is provided with lift pins (not illustrated). Delivery of the substrate W is performed between a substrate transfer mechanism disposed outside the processing container 71 and the stage 81 via the lift pins.

A temperature adjuster 82 is embedded in the stage 81, and a temperature of the substrate W placed on the stage 81 is brought to a preset temperature. The temperature adjuster 82 is configured as, for example, a flow path that forms a portion of a circulation flow path through which a temperature adjusting fluid such as water flows, and the temperature of the substrate W is adjusted by heat exchange with the fluid. However, the temperature adjuster 82 is not limited to such a flow path of a fluid, and may be configured as, for example, a heater that performs resistance heating. A temperature of the substrate W (a surface temperature of the stage 81) when the etching gas is supplied is, for example, -50 degrees C to 200 degrees C.

In addition, one end of an exhaust pipe 83 is open to the processing container 71, and the other end of the exhaust pipe 83 is connected to an exhauster 85 configured by, for example, a vacuum pump, via a valve 84 which is a pressure changing mechanism. By adjusting an opening degree of the valve 84, a pressure inside the processing container 71 becomes a predetermined pressure, and the substrate W is subjected to the etching process. The predetermined pressure is, for example, 0.133 Pa to 1.3×10⁴ Pa.

At an upper side in the processing container 71, a gas shower head 86 is provided to face the stage 81. Downstreams of gas supply paths 91 to 94 are connected to the gas shower head 86, and upperstreams of the gas supply paths 91 to 94 are connected to gas supply sources 96 to 99 via respective flow rate adjusters 95. Each of the flow rate adjuster 95 includes a valve and a mass flow controller. Each of the gases supplied from the gas supply sources 96 to 99 is supplied to the downstream and stopped from being supplied to the downstream by opening and closing of the valve included in the respective flow rate adjusters 95. Further, flow rates of the gases supplied to the downstreams are adjusted by the respective flow rate adjusters 95. A gas supply is constituted by the gas shower head 86, the flow rate adjusters 96, and the gas supply sources 96 to 99.

F₂ gas, TMA gas, N₂ gas, and NH₃ gas are supplied from the gas supply sources 96, 97, 98, and 99 respectively, and are supplied into the processing container 71 via the gas shower head 86. By using the respective flow rate adjusters 95, the supply of the gases may be performed independently from one another. The N₂ gas, which is an inert gas, is a carrier gas, and is supplied together with the etching gas into the processing container 71 via the gas shower head 86. When the etching method according to the first embodiment is performed, the F₂ gas and the TMA gas are supplied as the etching gas to the gas shower head 86. When the etching method according to the second embodiment is performed, the F₂ gas, the TMA gas, and the NH₃ gas are supplied as the etching gas to the gas shower head 86.

In addition, the etching apparatus 1A includes a controller 50 which is a computer, and the controller 50 includes a program, a memory, and a CPU. The program includes instructions (each step) to perform the above-described processing of the wafer W and the transfer of the wafer W, and this program is stored in a non-transitory computer-readable storage medium such as, for example, a compact disk, a hard disk, a magneto-optical disk, and a DVD, and is installed in the controller 50. The controller 50 outputs control signals to each portion of the etching apparatus 1A according to the program, and controls the operation of each portion. Specifically, operations of the etching apparatus 1A that are controlled as described above, may include adjustments of a temperature of a fluid supplied to the stage 81, the supply and stop of each gas from the gas shower head 86, the exhaust flow rate by the valve 84, and the like.

### (Modification)

The etching methods according to the first and second embodiments are not limited to being applied to substrates W having the structure described in FIG. 1. For example, the etching methods in which the Si layers 11 are selectively etched, may also be applied to substrates W in which the Si layers 11 and SiGe layers 12 are adjacent to each other in the horizontal direction and are exposed to a surface of the substrate, . Even in this case, the etching rate of the interface vicinity region 19 of the Si layer 11 can be prevented from becoming larger than that of the etching in the comparative embodiment, and the shape of the Si layer 11 after the etching can be controlled. In other words, a direction in which the Si layers 11 and the SiGe layers 12 are adjacent to each other is not limited to the vertical direction.

In addition, even when another germanium-containing layer such as a Ge layer instead of SiGe layer 12 is adjacent to the Si layer 11, and a content ratio of Ge in the interface vicinity region 19 of the Si layer 11 becomes relatively high, it is considered possible to suppress the etching rate of the interface vicinity region 19 by the etching method according to the first or second embodiment. That is, even when a germanium-containing layer other than the SiGe layer 12 is adjacent to the Si layer 11, it is considered possible to control the shape of the Si layer 11, according to the present technology. Further, the present disclosure is not limited to the etching Si layers that are adjacent to different kinds of layers as described above, and is also applicable to simply etching a Si layer 11 exposed over substantially the entire surface of the substrate W. In this case, it is possible to suppress the roughness of the Si layer 11 after the etching. Although a polysilicon layer is etched as a silicon layer in the evaluation test to be described later, the silicon layer etched according to this technology is not limited to polysilicon, and amorphous silicon may be used. The silicon layer may also be a silicon layer containing a doping element such as phosphorus.

In addition, in the first and second embodiments, by supplying a plurality of gases constituting the etching gas simultaneously, the etching rate is increased by increasing partial pressure of the etching gas around the substrate W. However, the gases constituting the etching gas are not limited to being simultaneously supplied, and may be sequentially supplied. Specifically, in the first embodiment, the F₂ gas and the TMA gas may be sequentially and repeatedly supplied into the processing container 71, and in the second embodiment, the F₂ gas, the TMA gas, and the NH₃ gas may be sequentially and repeatedly supplied into the processing container 71. When the gases constituting the etching gas are sequentially supplied as described above, between supplying one gas constituting the etching gas and then another, purging the gas remaining in the processing container 71 may be performed by supplying an inert gas such as N₂ gas as a purge gas into the processing container 71.

In the present disclosure, supplying each of the gases simultaneously to the substrate W means that timings at which the gases start to be supplied to the substrate W are identical and that timings at which the supplies of the gases to the substrate W are stopped are identical. Therefore, supplying each gas simultaneously includes overlapping of the periods during which the gases are supplied to the substrate W. Even though it is desirable to supply the gases simultaneously in order to increase pressure of the etching gas around the substrate W, the timings at which the supplies of the gases constituting the etching gas starts and/or the timings at which the supplies of the gases constituting the etching gas are stopped may be different from each other. That is, a period in which one gas constituting the etching gas is supplied and a period in which another gas constituting the etching gas is supplied may overlap only partially.

In addition, although the above-described etching gas includes F₂ gas which is a fluorine-containing gas as a halogen-containing gas, the present disclosure is not limited to fluorine-containing gas as the halogen-containing gas, and a halogen-containing gas including other halogen molecules, such as chlorine (Cl) or bromine (Br), may be used. Further, the present disclosure is not limited to using F₂ gas as the fluorine-containing gas, and for example, IF₇ gas, IF₅ gas, ClF₃ gas, or SF₆ gas may be used.

In addition, although the above-described etching gas includes TMA gas, the present disclosure is not limited thereto, and the etching gas may include other amine gases. The other amine gases may be gases made of any primary, secondary, and tertiary amines. Specifically, monomethylamine (CH₃NH₂), which is a primary amine, dimethylamine ((CH₃)₂NH), which is a secondary amine, triethylamine ((CH₃CH₂)₃N), which is a tertiary amine, and the like may be used.

As described above, the etching gas may contain components such as F₂, amine, and NH₃, and the layer (film) adjacent to the Si layer, which is an etching target layer, may contain Ge as a component. In the present disclosure, when a gas or a film is described as containing a certain component, it does not mean containing the component as an impurity but means containing the component as a constituent component of the gas or the film.

The above-described embodiments according to the present disclosure should be considered exemplary and not limitative in all respects. Each of the above-described embodiments may be omitted, substituted, modified and combined in various ways without departing from the scope of the disclosure and appended claims.

### [Evaluation Test]

Evaluation tests performed on the etching process according to the present disclosure are described below.

### <Evaluation Test 1>

In Evaluation Test 1, the etching process of the comparative embodiment was performed using the etching apparatus 1A on a substrate B1 for testing, which has the stack structure described with reference to FIG. 1. That is, in Evaluation Test 1, F₂ gas and NH₃ gas were used as the etching gas. The processing was performed by preparing a plurality of substrates B1 and setting different etching times (supply time of the etching gas) for the respective substrates B1. Specifically, the etching times were set to 60 sec, 120 sec, and 175 sec. Except for the etching times, the substrates B1 were etched under the same processing conditions. In performing the processing, the pressure inside the processing container 71 and a temperature of the substrate B1 were set to values within ranges described in the embodiment, and flow rates of the F₂ gas and the NH₃ gas supplied to the substrate W (i.e., supplied into the processing container 71) were set to satisfy the flow rate of the NH₃ gas/the flow rate of the F₂ gas=0.02. Then, SEM images of the substrate B1 acquired before and after the etching process were compared to detect etching amounts of sidewalls of Si layers 11, and an average value of the detected etching amounts was calculated. Similar to the Si layers 11, etching amounts of sidewalls of SiGe layers 12 were detected, and an average value of the detected etching amounts was calculated. Further, flow rates of the N₂ gas and the F₂ gas, supplied to the substrate W, were set to satisfy the flow rate of the N₂ gas/the flow rate of the F₂ gas=1.6, and this was applied to other subsequent evaluation tests in the same manner.

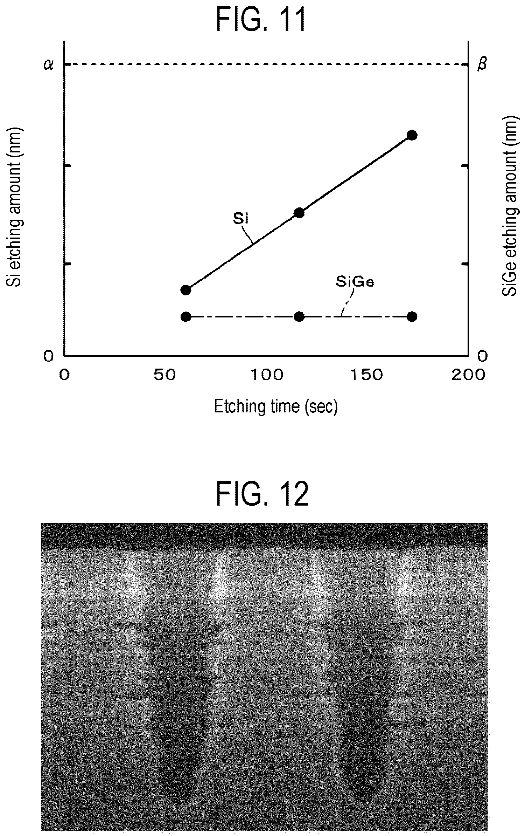

FIG. 11 shows a result of Evaluation Test 1. The horizontal axis of the graph represents etching time, and the vertical axis of the graph represents respective average values of the etching amounts of the Si layers 11 and the etching amounts of the SiGe layers 12. Vertical axis scales of the Si layer 11 and the SiGe layer 12 are respectively given constant increments of etching amounts. However, sizes of these increments are different. That is, a size (referred to as A nm) of the etching amount per one scale of the Si layer 11 is different from a size (referred to as B nm) of the etching amount per one scale of the SiGe layer 12, and A nm>B nm. A scale of the Si layer 11 and a scale of the SiGe layer 12 positioned at the same height in the graph, are respectively represented as α and β, but α is approximately 3.3 times of β.

As shown in the graph, the average value of etching amounts of the Si layers 11 increases as etching time increases, and the etching time and the average value of etching amounts of the Si layers 11 are substantially proportional. On the other hand, the average value of the etching amounts of the SiGe layers 12 is substantially constant. Further, an average value of etching amounts of the Si layers 11 at an etching time of 60 sec, which is the shortest etching time among the set etching times, is larger than an average value of etching amounts of the SiGe layers 12 at each etching time. As such, Evaluation Test 1 shows a result in which a selective etching of the Si layers 11 among the Si layers 11 and the SiGe layers 12 was shown.

However, as described in the embodiment, in Evaluation Test 1, the rectangularity of the recess 18 was low. FIG. 12 shows a SEM image of a substrate B1 processed with the etching time set to 175 sec. It was confirmed from the image that, as described with reference to FIGS.2 and 3, the interface vicinity regions 19 of the Si layers 11 were significantly etched compared to other regions.

### <Evaluation Test 2>

A substrate B2 having a polysilicon layer formed on a surface thereof was subjected to an etching process for a predetermined time in the same manner as in Evaluation Test 1. Except for the etching time, processing conditions were the same as the processing conditions of Evaluation Test 1. A surface of the substrate B2 was photographed and observed before and after the etching process. The above-described polysilicon layer was formed on the flat substrate B2 on which no pattern was formed. Therefore, the stack structure 10 described with reference to FIG. 1 is not formed in the substrate B2.

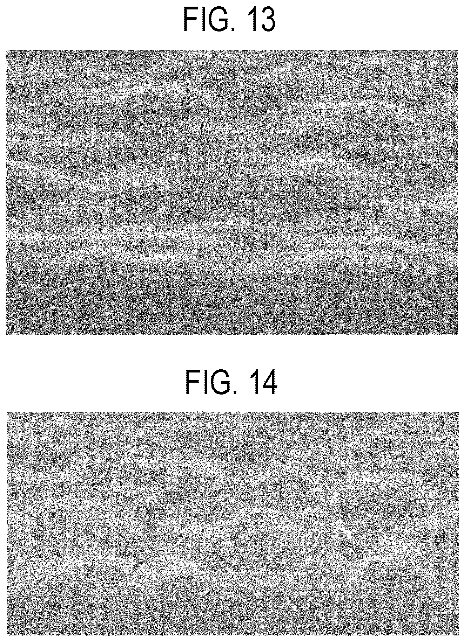

FIG. 13 shows the surface of the substrate B2 before the etching process, and FIG. 14 shows the surface of the substrate B2 after the etching process. From FIGS. 13 and 14 it can be seen that the etching process forms considerable irregularities on the surface, and increases roughness. As described in the embodiment, a by-product is generated during the etching, and it is considered that the roughness increases due to the polysilicon layer being etched while being coated by the by-product. A by-product is also generated when etching the Si layers 11 constituting the stack structure 10, and therefore, it is considered that the roughness of the Si layers 11 increases after etching.

### <Evaluation Test 3>

In Evaluation Test 3, etching was performed on the substrate B1 for testing, using the F₂ gas and the TMA gas described in the first embodiment, and average values of etching amounts of the Si layers 11 and the SiGe layers 12 were calculated as in Evaluation Test 1. Therefore, in Evaluation Test 3, the TMA gas is used instead of the NH₃ gas used in Evaluation Test 1 as a gas constituting the etching gas. Etching times for each of the substrates in Evaluation Test 3 were 60 sec, 90 sec, and 120 sec. Except for the etching times set as described above and using the TMA gas as the etching gas, the etching process was performed in the same manner as in Evaluation Test 1. Further, in Evaluation Test 3, the flow rate of the TMA gas supplied to the substrate W/the flow rate of the F₂ gas supplied to the substrate W was 0.02, which is the same as the flow rate of the NH₃ gas/the flow rate of the F₂ gas in Evaluation Test 1.

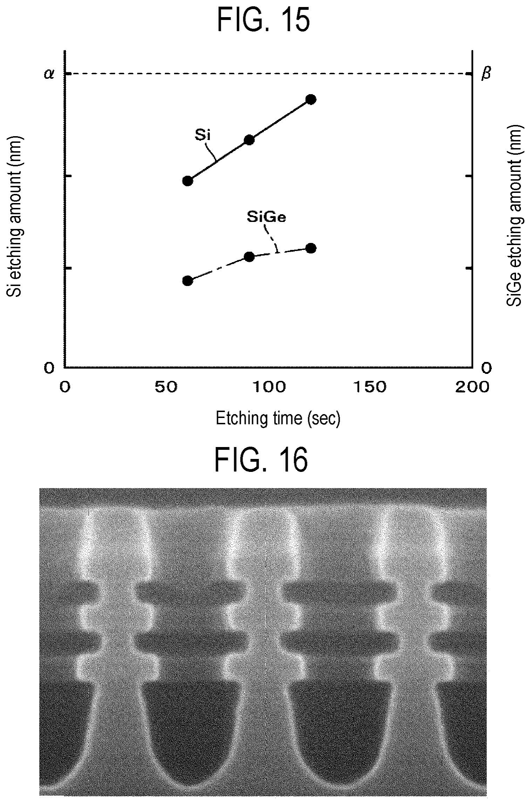

FIG. 15 shows a result of Evaluation Test 3. The vertical axis and the horizontal axis of the graph of FIG. 15 are set in the same manner as the vertical axis and the horizontal axis of the graph of FIG. 13 in Evaluation Test 1. As shown in the graph, the average value of etching amounts of the Si layers 11 increases as etching time increases, and the etching time and the average value of etching amounts of the Si layers 11 are substantially proportional. On the other hand, the average value of the etching amounts of the SiGe layers 12 is substantially constant. Further, an average value of etching amounts of the Si layers 11 at an etching time of 60 sec, which is the shortest etching time among the set etching times, is larger than an average value of etching amounts of the SiGe layers 12 at each etching time. The above result shows that even when TMA gas is used instead of NH₃ gas, etching selectivity of the Si layers 11 among the Si layers 11 and the SiGe layers 12 is ensured.

In addition, comparing the graph of FIG. 15 with the graph of FIG. 13 shows that when the etching time is the same, an average value of etching amount of Si is larger in Evaluation Test 3 than in Evaluation Test 1. That is, it was confirmed in Evaluation 3 that the etching rate of the Si layers 11 can be increased by using TMA gas as the etching gas, instead of NH₃ gas. Further, when the etching times were 60 sec and 120 sec, average values of etching amounts of Si layers 11 in Evaluation Test 3 were respectively 1.67 times and 2.67 times of the average values of the etching amounts of the Si layers 11 in Evaluation Test 1. FIG. 16 shows a SEM image of the substrate B1 etched for an etching time of 90 sec in Evaluation Test 3. As shown in the image, the rectangularity of the formed recess 18 is high.

### <Evaluation Test 4>

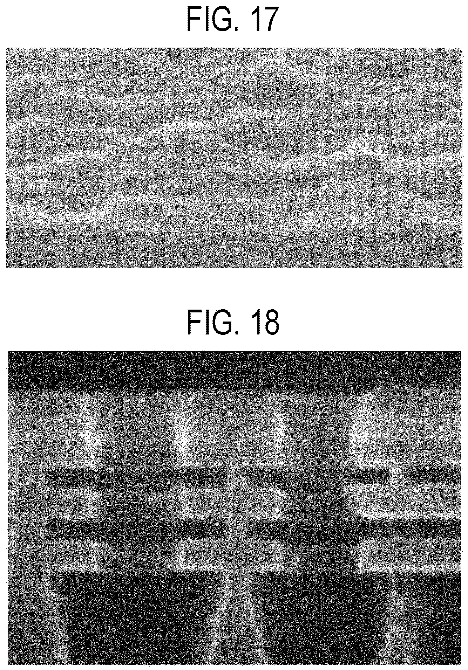

Except for the use of F₂ gas and TMA gas as the etching gas as in Evaluation Test 3, an etching process was performed on the substrate B2 under the same processing conditions as in Evaluation Test 2, and a surface of the substrate B2 was photographed and observed after the processing. FIG. 17 shows the surface of the substrate B2 after the etching process. Compared with the image of FIG. 13 before the etching process described in Evaluation Test 2, the image of FIG. 17 shows no significant change in the roughness of the surface of the polysilicon layer. Further, compared to the image of FIG. 14 after the etching process in Evaluation Test 2, it can be seen that the image of FIG. 17 shows that the roughness of the surface of the polysilicon layer is suppressed. This is considered to be due to the fact that, as described in the embodiment, the by-product generated when the TMA gas is used is different from that generated when the NH₃ gas is used, and sublimabilities of these by-products are different from each other. Therefore, it is predicted that when etching the Si layers 11 constituting the stack structure 10, the roughness of the Si layers 11 is also suppressed in the same manner as the polysilicon layer in Evaluation Test 4.

As described above, the results of Evaluation Tests 1 to 4 show that, by using F₂ gas and TMA gas as the etching gas when etching the Si layers 11 of the stack structure 10, the etching rate, the rectangularity of the formed recess 18, and the smoothness of the Si layers after the etching can be relatively high.

### <Evaluation Test 5>

In Evaluation Test 5, an etching was performed on the substrate B1 for testing, using the F₂ gas, the TMA gas, and the NH₃ gas, described in the second embodiment, and average values of etching amounts of the Si layers 11 and the SiGe layers 12 were calculated as in Evaluation Tests 1 and 3. Therefore, in Evaluation Test 5, as gases constituting the etching gas, the same gases as those used in Evaluation Test 3 were used, with an addition of the NH₃ gas, which was used in Evaluation Test 1. In Evaluation Test 5, the etching time was set to 90 sec.

Regarding flow rates of the gases supplied to the substrate W in Evaluation Test 5, the flow rate of the F₂ gas/(the flow rate of the TMA gas+the flow rate of the NH₃ gas) is 0.02, which is the same as the flow rate of the F₂ gas/the flow rate of the NH₃ gas in Evaluation Test 1 and the flow rate of the F₂ gas/the flow rate of the TMA gas in Evaluation Test 3. Further, in Evaluation Test 5, the flow rate of the TMA gas/the flow rate of the NH₃ gas is set to 1. In addition, except for the flow rates of the gases, other processing conditions such as the temperature of the substrate B1 are the same as the processing conditions set in Evaluation Tests 1 and 3.

Comparing the result of Evaluation Test 3 in which the etching time is 90 sec with a result of Evaluation Test 5, the average value of the etching amounts of the Si layers 11 in Evaluation Test 5 was 3.69 times the average value of the etching amounts of the Si layers 11 in Evaluation Test 3. Further, the average value of the etching amounts of the SiGe layers 12 in Evaluation Test 5 was 1.28 times the average value of the etching amounts of the SiGe layers 12 in Evaluation Test 3. Therefore, comparing the result of Evaluation Test 5 with the result of Evaluation Test 3 shows that while there is no significant change in the etching amount of the SiGe layers 12, the etching amount of the Si layers 11 is significantly increased. That is, while ensuring the etching selectivity of the Si layers 11 among the Si layers 11 and the SiGe layers 12, the etching rate of the Si layers 11 is increased compared to that of Evaluation Test 3, which is a desirable result. FIG. 18 shows an image of the substrate B1 after the etching process in Evaluation Test 5. As is clear from comparison with the image of FIG. 16 in Evaluation Test 3, the rectangularity of the recess 18 is higher.

In Evaluation Test 3, the flow rate of the TMA gas/the flow rate of the F₂ gas is set as 0.02 as described above. Further, in Evaluation Test 5, since the flow rate of the TMA gas is 1/2 of the flow rate of the TMA gas in Evaluation Test 3, the flow rate of the TMA gas/the flow rate of the F₂ gas is 0.01. Since etching process was performed preferably in each of Evaluation Tests 3 and 5, it can be seen that the flow rate of the TMA gas/the flow rate of the F₂ gas is preferably 0.01 or more.

In addition, it is considered that since an effect of suppressing etching in the interface vicinity region 19 by using the TMA gas and an effect of promoting etching in the interface vicinity region 19 by using the NH₃ gas were balanced, and the etching was performed as described in FIGS. 7 to 9, thereby enhancing the rectangularity of the recess 18. As described above, in Evaluation Test 5, the flow rate of the TMA gas/the flow rate of the NH₃ gas is set to 1, but even in a case in which the ratio of the flow rates of the TMA gas and the NH₃ gas deviates slightly from 1, it is considered that the above-described balance will not be disrupted. However, it is considered that, if the value of the flow rate of the TMA gas/the flow rate of the NH₃ gas is excessively small, an effect of the NH₃ gas increases, and therefore, problems described in the comparative embodiment may occur. Further, if the value of the flow rate of the TMA gas/the flow rate of the NH₃ gas is excessively large, the action of the NH₃ gas decreases, and therefore, the etching rate of the interface vicinity region 19 is reduced as described in FIGS. 7 to 9. Based on this, it is considered desirable for the flow rate of the TMA gas/the flow rate of the NH₃ gas to be, for example, 0.25 to 4.0.

### EXPLANATION OF REFERENCE NUMERALS

W: substrate, 11: Si layer

## Claims

1. An etching method, comprising: etching a silicon layer by supplying a halogen-containing gas and an amine gas to a substrate including the silicon layer formed on a surface of the substrate.

2. The etching method of Claim 1, wherein the halogen-containing gas is fluorine gas.

3. The etching method of Claim 2, wherein, a germanium-containing layer is formed adjacent to the silicon layer in the substrate,
wherein each of the silicon layer and the germanium-containing layer is exposed to the surface of the substrate, and
wherein the etching is selective etching of the silicon layer among the silicon layer and the germanium-containing layer.

4. The etching method of Claim 3, wherein the germanium-contain layer is a silicon germanium layer.

5. The etching method of Claim 4, wherein the silicon layer and the silicon germanium layer are alternately stacked on the substrate.

6. The etching method of Claim 1, wherein the etching includes supplying the halogen-containing gas and the amine gas to the substrate such that a period during which the halogen-containing gas is supplied and a period during which the amine gas is supplied overlap each other.

7. The etching method of Claim 6, wherein a flow rate of the amine gas supplied to the substrate/a flow rate of the halogen-containing gas supplied to the substrate is 0.01 or more.

8. The etching method of Claim 2, wherein the etching includes supplying ammonia gas to the substrate.

9. The etching method of Claim 8, wherein the etching includes supplying the halogen-containing gas, the amine gas, and the ammonia gas to the substrate such that a period during which the halogen-containing gas is supplied, a period during which the ammine gas is supplied, and a period during which the ammonia gas is supplied respectively overlap one another.

10. The etching method of Claim 1, wherein the amine gas is trimethylamine gas.

11. An etching apparatus, comprising:
a processing container configured to store a substrate including a silicon layer formed on a surface of the substrate; and
a gas supply configured to supply a halogen-containing gas and amine gas into the processing container to etch the silicon layer.
